# EUROPÄISCHE PATENTSCHRIFT

(11) **EP 3 109 999 B1**
(45) Veröffentlichungstag und Bekanntmachung des Hinweises auf die Patenterteilung: **26.01.2022**
(21) Anmeldenummer: 16175377.7
(22) Anmeldetag: 21.06.2016
(51) Int. Cl.: H02P 23/14, H02P 31/00

(54) **VERFAHREN UND VORRICHTUNG ZUR ERMITTLUNG EINER PHYSIKALISCHEN GRÖSSE EINER MEHRPHASEN-SYNCHRONMASCHINE**
METHOD AND DEVICE FOR DETERMINING A PHYSICAL VARIABLE OF A MULTI-PHASE SYNCHRONOUS MACHINE
PROCEDE ET DISPOSITIF DE DETERMINATION D'UNE GRANDEUR PHYSIQUE D'UNE MACHINE SYNCHRONE MULTIPHASEE

(30) Priorität: 25.06.2015 AT 505532015
(43) Veröffentlichungstag der Anmeldung: 28.12.2016
(73) Patentinhaber: B&R Industrial Automation GmbH, 5142 Eggelsberg (AT)
(72) Erfinder: Mayrhofer, Andreas, 4850 Timelkam (AT)
(74) Vertreter: Patentanwälte Pinter & Weiss OG

(56) Entgegenhaltungen:
- DE-A1-102010 006 593
- DE-A1-102010 006 594
- DE-A1-102011 108 417
- DE-B3-102006 042 038

## Beschreibung

Die Erfindung betrifft ein Verfahren und eine Vorrichtung zur sicheren Ermittlung einer Zustandsgröße einer Drehstrom-Synchronmaschine, die von einem Mehrphasenstromnetz mit zumindest n≥3 Phasen, mit elektrischem Strom versorgt wird, wobei Stromwerte von n-1 Phasenströmen aus zumindest n-1 Phasen eines Mehrphasenstromnetzes erfasst werden und mittels der zumindest n-1 ersten aktuellen Stromwerte eine Zustandsgröße berechnet wird, wobei Stromwerte aller n Phasenströme aus dem n-phasigen Mehrphasenstromnetz erfasst werden und die n Phasenströme miteinander verknüpft werden und das Ergebnis der Verknüpfung aller n Phasenströme für eine Plausibilitätsprüfung der für die Ermittlung der Zustandsgröße verwendeten n-1 Phasenströme herangezogen wird, wobei aus den zumindest n-1 Stromwerten ein Stromraumzeiger ermittelt wird. Weiters betrifft die Erfindung die Verwendung des Verfahrens zum sicheren Betreiben einer Drehstrom-Synchronmaschine.

Im Zusammenhang mit elektrischen Antrieben, in Form von mit Elektromotoren angetriebenen Bauteilen, finden die unterschiedlichsten Sicherheitsfunktionen und Sicherheitsüberwachungen Anwendung. Deren Aufgabe besteht darin, die Risiken sowohl für Mensch als auch für den elektrischen Antrieb selbst bzw. damit angetriebenen Anlagen, zu reduzieren.

Zu einer der gängigsten Überwachungsfunktionen, in Verbindung mit elektrischen Antrieben, gehört das sicher begrenzte Moment. Im Allgemeinen wird in diesem Zusammenhang von der "Safe Limited Torque Funktion" bzw. der "SLT-Funktion" gesprochen, weshalb im Weiteren auch nur noch die Bezeichnung SLT-Funktion genutzt wird.

Aufgabe einer SLT-Funktion ist es, zu verhindern, dass ein elektrischer Antrieb einen Grenzwert bzw. ein festgelegtes Drehmoment, oder bei der Nutzung eines Linearmotors eine festgelegte Kraft überschreitet. Dazu wird in der Regel das aktuelle Drehmoment des Elektromotors, bzw. die aktuelle Kraft im Falle eines Linearmotors, oder ein Drehmoment an einer anderen Stelle des Antriebs, durch die SLT-Funktion überwacht. Im Weiteren wird in Folge oftmals ein Drehmoment des elektrischen Antriebs erwähnt, wobei die Ausführungen in analoger Weise auch für die Kraft eines Linearmotors gelten.

Dadurch, dass ein zulässiger Wert des Drehmomentes des elektrischen Antriebs nicht überschritten wird, ergibt sich eine gewisse Sicherheitsfunktion, beispielsweise wenn Fremdkörper in eine vom elektrischen Antrieb angetriebene Anlage eingezogen werden. Dabei kann durch die Sicherheitsfunktion beispielsweise der Antrieb drehmomentfrei geschaltet werden, oder auch lediglich eine Warnmeldung ausgegeben werden. Dies trägt dazu bei, dass beispielsweise das Bedienpersonal einer Anlage, bzw. die Anlage selbst vor Schaden bewahrt werden kann. Ein Überschreiten eines zulässigen Drehmoments wird zuerst durch die SLT-Funktion registriert. Grundsätzlich muss, um eine vorliegende Gefahrensituation beurteilen zu können, das aktuelle Drehmoment bestimmt werden. Da die Entscheidung zur Deaktivierung des Antriebs, oder die Ausgabe eines Warnsignals auf diese Bestimmung des Drehmoments basiert, erfolgt diese meistens mehrkanalig, um durch Redundanz eine gewisse Sicherheit zu garantieren. Das Drehmoment (Kraft) ist allerdings nur eine Zustandsgröße des elektrischen Antriebs, auf die die SLT-Funktion abstellen kann. Anstelle des Drehmoments könnten auch die Motorströme überwacht werden. Ebenso könnte die Momentanleistung des Elektromotors als Zustandsgröße herangezogen werden. Wesentlich hierbei ist, dass die SLT-Funktion auf eine erfassbare oder ermittelbare Zustandsgröße des elektrischen Antriebs, auf deren Richtigkeit vertraut werden kann, abstellt.

Dazu sieht beispielsweise die DE 10 2010 006 593 A1 vor, das Drehmoment eines elektrischen Antriebs mittels eines errechneten Stromraumzeigers zu bestimmen. Dazu wird zunächst in zumindest zwei Phasen des genutzten Dreiphasennetzes ein Stromsensor angeordnet. Die erfassten aktuellen Stromwerte werden einem Sicherheitswächter zugeführt, welcher wiederum den Stromraumzeiger errechnet und somit ein momentanes Drehmoment bestimmt. Um die Bestimmung des Stromraumzeigers in dieser Form mit einer gewissen Sicherheit zu versehen, wird zusätzlich auch in der dritten Phase ein Stromsensor angeordnet. Somit stehen drei unterschiedliche Strompaare zur Bestimmung des Stromraumzeigers zur Verfügung. Aus jedem dieser Strompaare lässt sich ein Stromraumzeiger bzw. ein momentan wirkendes Drehmoment bestimmen. Die aus den Strompaaren bzw. Stromraumzeigern berechneten Drehmomente, werden miteinander verglichen. Eine Abweichung der errechneten Drehmomente weist auf einen möglichen Fehler in der Erfassung der Strompaare oder deren Berechnung hin. In Folge einer derartigen Abweichung wird ein Abschalten der Leistungselektronik des Antriebssystems (Safe Torque Off, STO) veranlasst. Die DE 10 2010 006 593 A1 wird nachfolgend noch mit Bezugnahme auf die Fig.4 näher erläutert.

Zur Berechnung des Stromraumzeigers werden in der DE 10 2010 006 593 A1 zwei getrennte Schaltungen genutzt, welche jeweils einen eigenen Mikrocontroller aufweisen. Jeder der Mikrocontroller nutzt ein anderes Strompaar für die Berechnung des Stromraumzeigers bzw. des Drehmoments. Dabei ist jedoch zu beachten, dass in einem Dreiphasennetz drei aktuelle Stromwerte zu Verfügung stehen. Daher muss bei der doppelten Berechnung durch zwei Mikrocontroller einer der aktuellen Stromwerte doppelt zur Berechnung herangezogen werden. Im Falle eines schadhaften Sensors, welcher jenen aktuellen Stromwert erfasst, der doppelt herangezogen wird, wird beiden Mikrocontrollern ein fehlerhafter Wert als Berechnungsbasis zugeführt. Trotz fehlerhafter Messung des Stromwertes würden damit beide Mikrocontroller dasselbe, falsche Drehmoment berechnen. Der Vergleich der berechneten Drehmomente würde damit keinen Fehler anzeigen, womit der Antrieb möglicherweise nicht stillgesetzt wird, obwohl ein kritisches Drehmoment überschritten wird.

Sollte im Dreiphasennetz das mögliche weitere, dritte Strompaar zur weiteren Kontrolle herangezogen werden, hat einer der beiden Mikrocontroller die Rechenoperation zweimal durchzuführen. Zwar steht auf diese Weise ein dritter Wert zur Kontrolle des errechneten Drehmoments zur Verfügung, dabei ist jedoch auch ein möglicher Fehler in einem der beiden Mikrocontroller zu berücksichtigen. Unter Umständen führt ein fehlerhaft gemessener aktueller Stromwert in Kombination mit einem fehlerhaften Mikrocontroller dazu, dass ein Fehler beim Vergleich der letztlich fehlerbehafteten Drehmomente nicht detektiert wird.

Damit kann das für das sichere Stillsetzen des Antriebs benötigte Drehmoment gemäß dem Stand der Technik nicht mit ausreichender Sicherheit ermittelt werden, bzw. kann es Situationen geben, in denen ein fehlerhaft ermitteltes Drehmoment nicht erkannt wird. Beides ist für eine Sicherheitsfunktion problematisch.

In der DE 10 2006 042 038 B3 werden alle Phasenströme erfasst und daraus eine drehmomentenbildende Stromkomponente ermittelt. Diese drehmomentenbildende Stromkomponente als Zustandsgröße wird in einer Grenzüberwachung mit einem Grenzwert verglichen. Zusätzlich erfolgt eine Plausibilisierung der erfassten Phasenströme durch die Bildung des Summenstromes aller Phasenströme. Durch diese Plausibilisierung gelten die an einkanalig 15 erfassten Phasenströme als zweikanalig erfasst. Für die Berechnung der Stromkomponente wird der Verdrehwinkel benötigt wird. Um auch den Verdrehwinkel zweikanalig zu erfassen, was für die Sicherheitsfunktion notwendig ist, sind zwei separate Geber notwendig, was den Aufwand deutlich erhöht. Die Lehre dieses Dokuments entspricht dem Oberbegriff der unabhängigen Ansprüche 1 und 9.

Die Aufgabe der vorliegenden Erfindung besteht darin, ein Verfahren und eine Vorrichtung zur sicheren Ermittlung einer Zustandsgröße einer in einem Mehrphasenstromnetz mit drei oder mehr Phasen befindlichen Drehstrom-Synchronmaschine anzugeben.

Diese Aufgabe wird durch die vorliegende Erfindung nach Ansprüche 1 und 9 dadurch gelöst, dass unter Verzicht auf eine Verwendung des Verdrehwinkels angenommen wird, dass der Stromraumzeiger einer maximalen drehmomentbildenden Stromkomponente entspricht wobei aus der maximalen drehmomentbildenden Stromkomponente die Zustandsgröße der Drehstrom-Synchronmaschine ermittelt wird. Dadurch wird in einem frühzeitigen Stadium geprüft, ob Stromwerte, welche zu weiteren Berechnungen herangezogen werden sollen, zur weiteren Berechnung geeignet bzw. plausibel sind.

Eine Überprüfung erfolgt somit nicht, wie im Falle des dreiphasen-Drehstromnetzes im Stand der Technik, durch den Vergleich zweier aus unterschiedlichen Stromwerten errechneten physikalischen Größen. Die erfassten aktuellen Stromwerte selbst werden in der vorliegenden Erfindung für eine Überprüfung herangezogen. Dadurch wird eine unmittelbare Kontrolle ermöglicht und Fehlerakkumulationen, durch weitere Zwischenschritte bzw. Berechnungen, werden minimiert.

In vorteilhafter Weise kann die Plausibilitätsprüfung derart erfolgen, dass das erste Kirchhoff'sche Gesetz, auch Knotenregel genannt, auf die aktuellen Phasenströme angewandt wird. Das erste Kirchhoff'sche Gesetz besagt, dass die Summe in einem Knotenpunkt Null ergeben muss, oder anders formuliert die Summe der zufließenden Ströme der Summe der abfließenden Ströme entsprechen muss. Die Anwendung des ersten Kirchhoff'schen Gesetzes ist im Falle einer vorliegenden Sternschaltung der Statorwicklungen direkt möglich, sofern der Sternpunkt nicht geerdet ist. Im Falle einer n-Eckschaltung der Statorwicklungen kann ebenso direkt eine Summenbildung der Phasenströme erfolgen. Aus dem Ergebnis der Summe ist eine einfache Kontrolle der Plausibilität der erfassten Ströme möglich.

In vorteilhafter Weise wird das Ergebnis der Plausibilitätsprüfung in Form eines Plausibilitätssignals ausgegeben. Eine derartige Ausgabe, welche beispielsweise zu einem optischen oder akustischen Hinweis führen kann, erlaubt es frühzeitig einen Fehler in der Erfassung der Stromwerte anzuzeigen oder einen erkannten Fehler auf andere Weise zu verarbeiten.

Eine vorteilhafte Ausgestaltung sieht vor, dass aus den zumindest n-1 ersten aktuellen, Stromwerten eine erste Stromkomponente gebildet wird. Diese erste Stromkomponente kann bereits selbst eine Zustandsgröße darstellen oder daraus eine weitere Zustandsgröße berechnet werden, beispielsweise mittels Verknüpfung mit einer Rechenkonstante. Dazu sieht eine vorteilhafte Ausgestaltung vor, dass als Zustandsgröße ein Drehmoment berechnet wird.

Vorteilhaft ist vorgesehen, dass die aktuell wirkende Zustandsgröße mit einem Grenzwert verglichen wird und ein Vergleichsergebnis ausgegeben wird. Der Vergleich gibt Auskunft über das Erreichen möglicher Bereiche, welche es beispielsweise aus Sicherheitsgründen zu vermeiden gilt. Die Ausgabe des Vergleichsergebnisses ermöglicht eine Vielzahl an möglichen Handlungen, welche basierend auf das Vergleichsergebnis gesetzt werden können.

Dabei kann vorteilhaft vorgesehen sein, dass das Erreichen oder Überschreiten des Grenzwertes eine Impulssperre auslöst. Infolge einer Impulssperre erhält der elektrische Antrieb bzw. die Mehrphasen-Synchronmaschine keinen Strom mehr, der zu einer Drehbewegung führen kann.

Die erfindungsgemäße Ausgestaltung kann auch mehrkanalig oder mit redundanten Bausteinen erfolgen, sodass eine gewisse Ausfallsicherheit gegeben ist. Die somit parallel ermittelten Ergebnisse können verglichen werden und im Falle der Ungleichheit kann ein Signal ausgegeben werden, oder die Impulssperre ausgelöst werden.

Die gegenständliche Erfindung wird nachfolgend unter Bezugnahme auf die Figuren 1 bis 7 näher erläutert, die beispielhaft, schematisch und nicht einschränkend vorteilhafte Ausgestaltungen der Erfindung zeigen. Dabei zeigt
Fig.1 die drei Phasen des dreiphasigen Mehrphasenstromnetzes mit dem statorfesten und dem rotorfesten Koordinatensystem,
Fig.2 die Erfassung zweier aktueller Stromwerte und die Bildung zweier Stromkomponenten,
Fig.3 die Bildung einer Zustandsgröße,
Fig.4 die zweikanalige Auswertung nach Stand der Technik,
Fig.5 das erfindungsgemäße Verfahren zur Berechnung einer Zustandsgröße,
Fig.6 Vergleich der aktuell wirkende Zustandsgröße mit einem Grenzwert und
Fig.7 eine Drehstrom-Synchronmaschine mit sicherer Ermittlung einer Zustandsgröße.
Fig.8 eine mehrkanalige Struktur der Erfindung

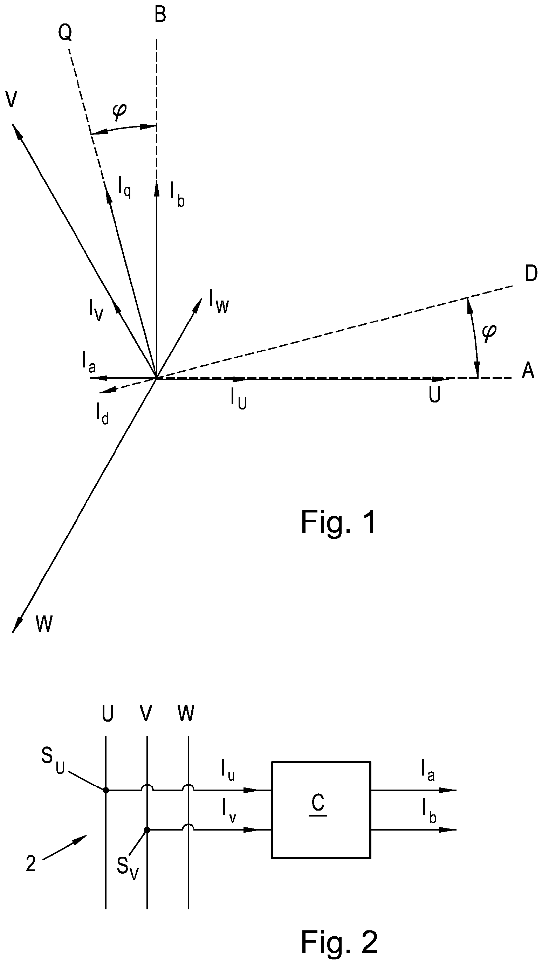

Die Figur 1 stellt die drei Phasen U, V und W eines Dreiphasen-Mehrphasenstromnetzes in bekannter sternförmiger Anordnung dar. Dabei kann zu jedem Zeitpunkt jeder Phase U, V, W ein aktueller Stromwert der Phasenströme Iᵤ, Iᵥ und I_{w} zugeordnet werden, wobei diese Phasenströme Iᵤ, Iᵥ I_{w}, entsprechend der sternförmigen Darstellung der drei Phasen U, V und W, um jeweils 360°/3=120° zueinander verdreht sind. Die Vektorsumme der Phasenströme Iᵤ, Iᵥ, und I_{w} ergibt bekannter Weise einen rotierenden Stromraumzeiger (nicht dargestellt). Dem Stator und dem Rotor einer Drehstrom-Synchronmaschine 1 wird üblicherweise jeweils ein zweiachsiges rechtwinkliges Koordinatensystem zugeordnet. In Figur 1 stellen die Achsen A und B die Achsen des zweiachsigen rechtwinkligen Koordinatensystems AB des Stators dar. Die Achsen Q und D bilden das zweiachsige rechtwinklige Koordinatensystem QD des Rotors, wobei dieses mit dem Rotor fest "verbunden" ist und somit mit dem Rotor rotiert.

In Figur 1 ist ein Zustand dargestellt, in welchem der Rotor, bzw. das rotorfeste Koordinatensystem QD, gegenüber dem Stator, bzw. dem statorfesten Koordinatensystem AB, um einen Verdrehwinkel ϕ verdreht ist, weshalb auch die entsprechenden, zugehörigen Koordinatensysteme QD, AB um den Verdrehwinkel ϕ zueinander verdreht dargestellt sind.

Mithilfe einer linearen Transformation, der bekannten Clarke-Transformation, ist es allgemein möglich n-phasige Größen der Drehstrom-Synchronmaschine 1, beispielsweise die n Phasenströme des Stators oder den Stromraumzeiger, in das zweiachsige statorfeste Koordinatensystem AB mit einer Komponente in Richtung der Achsen A und einer Komponente in Richtung der Achse B überzuführen. Die Wicklungen des Stators können jedoch in Stern oder in n-Eck geschaltet werden. Im Falle einer n-Eckschaltung muss bekanntermaßen berücksichtigt werden, dass die gemessenen Phasenströme Iᵤ,...,Iₙ der Phasen U,...,N über die bekannten n Wicklungsimpedanzen Z₁₂, Z₂₃,...,Zₙ₁ in die n Ströme der n Wicklungen (und damit in den Stromraumzeiger) umgerechnet werden, bevor eine Clarke-Transformation durchgeführt werden kann. Im Falle der Sternschaltung entsprechen die gemessenen Phasenströme Iᵤ,...,Iₙ in den Phasen U,...N bereits den Strömen in den Wicklungen. Unter Berücksichtigung, dass sowohl in Sternschaltung des Stators mit nicht geerdetem Sternpunkt, als auch in n-Eckschaltung des Stators, die Summe der aktuellen Stromwerte Iᵤ,...,Iₙ immer Null ist, ist bekanntermaßen das Erfassen von lediglich n-1 der aktuellen Phasenströme Iᵤ,...,Iₙ₋₁ notwendig, womit die Clarke-Transformation vereinfacht werden kann. Die nachfolgend beschrieben Erfindung ist damit gleichermaßen für eine Sternschaltung, als auch eine n-Eckschaltung der n Phasen der Drehstrom-Synchronmaschine 1 anwendbar. In weiterer Folge wird zur Beschreibung der Erfindung ohne Einschränkung der Allgemeinheit von einer Sternschaltung des Stators ausgegangen, weswegen auch auf die Phasenströme Iᵤ,...,Iₙ referenziert wird, da sie in diesem Fall mit den Strömen der Wicklungen identisch sind.

Im Falle des im Beispiel dargestellten dreiphasigen (n=3) Mehrphasenstromnetzes kann die Clarke-Transformation angewendet werden, um dreiphasige Größen, wie die aktuellen Stromwerte der Phasenströme Iᵤ, Iᵥ, I_{w} in das zweiachsige Koordinatensystem AB des Stators mit den Achsen A und B überzuführen. Unter Berücksichtigung, dass die Summe der drei aktuellen Stromwerte Iᵤ, Iᵥ, I_{w} immer Null ist, ist im Falle eines Dreiphasennetzes für die Clarke-Transformation das Erfassen von lediglich zwei (n-1) der drei (n) aktuellen Stromwerte Iᵤ, Iᵥ, I_{w} notwendig, wie in Fig.2 dargestellt. Aus zwei der drei, um 120° zueinander verdrehten, aktuellen Stromwerten Iᵤ, Iᵥ, I_{w} wird in einem Transformationsbaustein C mittels der Clarke-Transformation ein Stromraumzeiger gebildet, der im zweiachsigen statorfesten Koordinatensystem AB durch die zwei aufeinander normal stehende Stromkomponenten Iₐ und I_{b} dargestellt wird. Im Beispiel nach Fig. 2 werden beispielsweise an einer ersten Phase U und an einer zweiten Phase V der jeweilige aktuelle Stromwert der Phasenströme Iᵤ und Iᵥ des dreiphasigen Mehrphasenstromnetzes mittels entsprechender Sensoren Sᵤ und Sᵥ erfasst und im Park-Transformationsbaustein C in das zweiachsige Koordinatensystem AB des Stators übergeführt. Die in Fig. 2 dargestellte Auswahl der Phasenströme Iᵤ, Iᵥ, I_{w} ist dabei als lediglich beispielhaft anzusehen. Selbstverständlich wäre auch die Auswahl zweier anderer Phasenströme Iᵤ, Iᵥ, I_{w} möglich.

Unter Berücksichtigung des zuvor erwähnten Verdrehwinkels ϕ können mittels eines einfachen trigonometrischen Zusammenhangs auch eine entsprechende erste Stromkomponente I_{q} und eine zweite Stromkomponente I_{d} im zweiachsigen rechtwinkligen Koordinatensystem QD des Rotors mit den Achsen Q und D gebildet werden. Diese erste Stromkomponente I_{q} und zweite Stromkomponente I_{d} ergeben als vektorielle Summe den rotierenden Stromraumzeiger. Die erste Stromkomponente I_{q} und eine zweite Stromkomponente I_{d} können bekanntermaßen mittels der Park-Transformation aber auch direkt aus den gemessenen Phasenströmen Iᵤ, Iᵥ, I_{w} unter Zuhilfenahme des Verdrehwinkels ϕ ermittelt werden. Dazu ist es üblich, den Verdrehwinkel ϕ, der die Rotorlage repräsentiert, mittels entsprechender Sensorik, wie z.B. einem bekannten Drehwinkelgeber, zu erfassen. Die erste Stromkomponente I_{q} liegt quer zum Fluss des Rotor-Permanentmagneten und wird daher üblicherweise als Querstrom bezeichnet. Somit ist die erste Stromkomponente I_{q} jene Stromkomponente, welche für das Erzeugen des Drehmoments der Drehstrom-Synchronmaschine 1 verantwortlich ist. Dazu kann bekanntermaßen unter Verwendung einer entsprechenden Motor-Drehmomentkonstanten KT aus der errechneten ersten Stromkomponente I_{q} ein momentanes Drehmoment M der Drehstrom-Synchronmaschine 1 bestimmt werden.

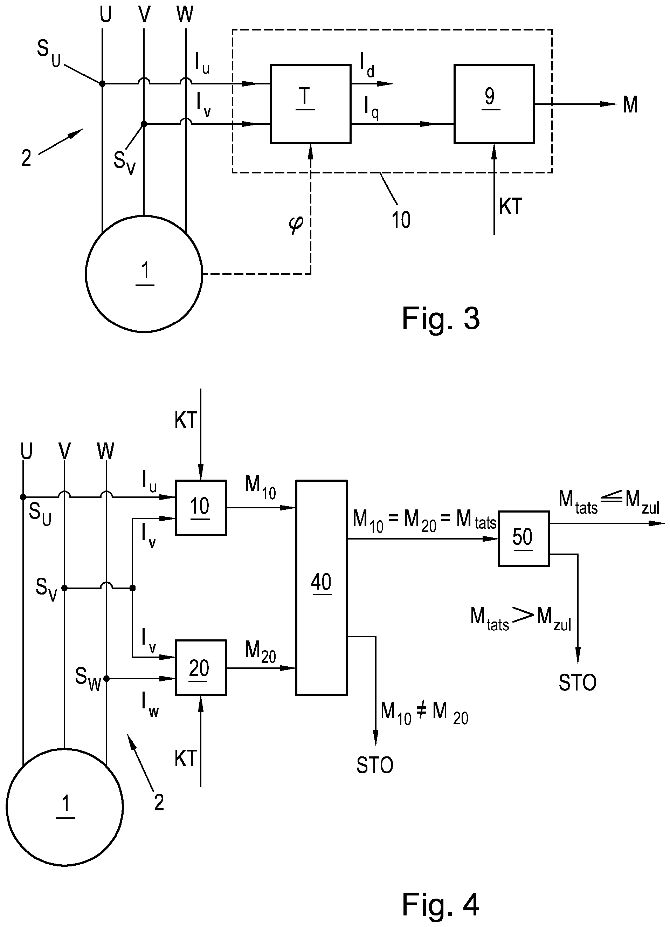

Die Stromkomponenten Iₐ, I_{b} des statorfesten Koordinatensystems bzw. gleichwertig die Stromkomponenten I_{q}, I_{d} des rotorfesten Koordinatensystems werden bekanntermaßen verwendet, um Zustandsgrößen der Drehstrom-Synchronmaschine 1, wie z.B. ein Drehmoment oder eine Leistung, zu ermitteln. Diese Stromkomponenten Iₐ, I_{b} und I_{q}, I_{d} können aber auch selbst als Zustandsgrößen angesehen werden. Fig. 3 zeigt beispielhaft, auf welche Weise eine Zustandsgröße G, hierein Drehmoment M, einer Drehstrom-Synchronmaschine 1 berechnet wird. Die mit den Stromsensoren Sᵤ, Sᵥ erfassten Phasenströme Iᵤ, Iᵥ werden im Transformationsbaustein T wie oben beschrieben in die Stromkomponenten Iₐ, I_{b} des statorfesten Koordinatensystems AB bzw. gleichwertig in die Stromkomponenten I_{q}, I_{d} des rotorfesten Koordinatensystems QD transformiert. Im Anschluss wird aus der drehmomentbildenden Stromkomponente I_{q} in der Berechnungseinheit 9 durch Multiplikation mit der bekannten Motor-Drehmomentkonstante KT der Drehstrom-Synchronmaschine 1 das Drehmoment M als Zustandsgröße G der Drehstrom-Synchronmaschine 1 berechnet.

Die Transformationseinheit T und die Berechnungseinheit 9 können dabei natürlich auch in einer Einheit integriert sein, z.B. in einem Berechnungsbaustein 10, wie in Fig. 3 angedeutet. Die Transformationseinheit T und die Berechnungseinheit 9 können als Hardware oder als Software ausgeführt sein.

Zur Berechnung der Zustandsgröße G kann dem Transformationsbaustein T auch der Verdrehwinkel ϕ zugeführt werden, um die obigen Transformationen berechnen zu können. In einer vereinfachten Ausführung kann auf den Verdrehwinkel ϕ auch verzichtet werden. In diesem Fall wird angenommen, dass der Stromraumzeiger der drehmomentenbildenden Stromkomponente i_{q} entspricht. Damit wird eine Stromkomponente i_{q,max} ermittelt, die größer als die, oder zumindest gleich der tatsächlich wirkenden, drehmomentbildende Stromkomponente I_{q} ist. Wird mit dieser Stromkomponente i_{q,max} die Zustandsgröße G berechnet, enthält die Zustandsgröße G somit eine Art Reserve, da die tatsächliche Zustandsgröße G niemals größer als die berechnete Zustandsgröße G sein kann.

Es sei an dieser Stelle angemerkt, dass die Anwendung für Linearmotoren nicht ausgeschlossen ist. Bei der Zustandsgröße G kann es sich in diesem Fall um eine Kraft, welche der Linearmotor aufbringt, handeln. Die obigen Ausführungen gelten dabei analog.

Das Drehmoment M der Drehstrom-Synchronmaschine 1 ist eine Zustandsgröße G, welche im Betrieb ein besonders hohes Gefahrenpotential mit sich bringen kann. Eine Drehstrom-Synchronmaschine 1 kommt beispielsweise bei Anlagen in der Produktions- und Fertigungstechnik als Antriebsmaschine zum Einsatz. Dabei ist das aufgebrachte Drehmoment M der Drehstrom-Synchronmaschine 1 letztlich für die möglichen auftretenden Kräfte verantwortlich. Um Schaden an Mensch und Maschine zu verhindern, darf das erzeugte Drehmoment M als Zustandsgröße G einen zuvor ausgewählten zulässigen Höchstwert G_{zul}, beispielsweise ein maximales Drehmoment M_{zul}, der Zustandsgröße nicht überschreiten, um beispielweise im Fall eines Verklemmens an oder in einer eben erwähnten Anlage Folgeschäden oder Verletzungen zu vermeiden. Solche Zustandsgrößen G werden daher oftmals redundant überwacht, insbesondere in sicherheitsgerichteten Anwendungen, in denen im Falle von Fehlern Gefahr für Mensch oder Maschine besteht. Dazu ist aber auch erforderlich, dass der ermittelten Zustandsgröße G vertraut werden kann.

Fig. 4 zeigt dazu eine redundante Überwachung nach dem Stand der Technik, wie z.B. in der DE 10 2010 006 593 A1 beschrieben. Dabei zeigt Fig. 4 eine zweikanalige Struktur mit zwei Berechnungsbausteinen 10 und 20. Innerhalb diesen wird jeweils, wie eben ausgeführt, ein Drehmoment M als Zustandsgröße G errechnet. Der erste Berechnungsbaustein 10 unterscheidet sich vom zweiten Berechnungsbaustein 20 durch die herangezogenen aktuellen Stromwerte der Phasenströme Iᵤ, Iᵥ, I_{w}. Der erste Berechnungsbaustein 10 bezieht über die Sensoren Sᵤ und Sᵥ zur Ermittlung des Drehmoments M die Phasenströme Iᵤ, Iᵥ der Phasen U und V heran. Der zweite Berechnungsbaustein 20 nutzt hingegen die aktuellen Phasenströme Iᵥ, I_{w} der Phasen V und W, welche über die Sensoren Sᵥ und S_{w} erfasst werden. Die beiden Berechnungsbausteine 10 und 20 geben somit ein erstes Drehmoment M₁₀ und ein zweites Drehmoment M₂₀ aus. Diese beiden Drehmomente M₁₀ und M₂₀ werden zur Ermittlung einer Abweichung zwischen den beiden, einem Vergleicher 40 zugeführt.

Bei einer korrekten Bestimmung der aktuellen Stromwerte Iᵤ, Iᵥ, I_{w} und einer fehlerfreien Berechnung des ersten Drehmoments M₁₀ und des zweiten Drehmoments M₂₀, ergibt der Vergleich der beiden Drehmomente M₁₀ und M₂₀ im Vergleicher 40 (innerhalb festgelegter Toleranzbänder) keine Abweichung. In diesem Fall wird davon ausgegangen, dass die Drehmomente M₁₀ bzw. M₂₀ einem tatsächlich vorhandenen Drehmoment Mₜₐₜₛ entsprechen. Das tatsächlich vorhandene Drehmoment Mₜₐₜₛ wird einem Vergleichsbaustein 50 zugeführt, wo es mit einem zulässigen Drehmoment M_{zul} verglichen wird. Dieses zulässige Drehmoment M_{zul} stellt beispielsweise einen oberen Grenzwert dar, bei dem gerade noch ein sicheres Betreiben der Drehstrom-Synchronmaschine 1 gewährleistet werden kann. Wird das zulässige Drehmoment M_{zul} überschritten, wird ein Stillsetzen der Drehstrom-Synchronmaschine 1 veranlasst. Selbiges erfolgt bei einer, durch den Vergleicher 40 detektierten, Abweichung der beiden Drehmomente M₁₀ und M₂₀ voneinander.

Dabei besteht jedoch die Gefahr, dass im Falle des oben ausgeführten Beispiels der Sensor Sᵥ fehlerhaft ist und ein falscher aktueller Stromwert Iᵥ in beiden Berechnungsbausteinen 10 und 20 zur Berechnung der Drehmomente M₁₀ bzw. M₂₀ herangezogen wird. In diesem Fall könnte es dazu kommen, dass ein Fehler in der Erfassung des aktuellen Stromwerts Iᵥ im Zuge des Vergleichs der beiden Drehmomente M₁₀ und M₂₀ nicht detektiert wird, da sich die beiden Drehmomente M₁₀ bzw. M₂₀ dennoch gleichen. Das kann dazu führen, dass ein berechnetes Drehmoment M₁₀, M₂₀ kleiner ist, als ein tatsächlich wirkendes Drehmoment. Ist das berechnete Drehmoment M₁₀, M₂₀ auch noch kleiner als das zulässige Drehmoment M_{zul}, könnte das zu einer Verletzung der Sicherheit der Drehstrom-Synchronmaschine 1 führen. Ein Schaden an Mensch oder Maschine könnte damit nicht ausgeschlossen werden.

Um dies zu vermeiden, kann in einer in Fig.4 nicht weiter dargestellten Variante, das weitere, verbleibende Strompaar Iᵤ und I_{w} zur Berechnung eines weiteren Drehmoments M₃₀ herangezogen werden. Dabei ist vorgesehen, dieses in einem der beiden vorhandenen Berechnungsbausteine 10 oder 20 zu bestimmen bzw. zu berechnen. Einer der Berechnungsbausteine 10 oder 20 berechnet daher zwei Drehmomente, beispielsweise M₁₀ und M₃₀, wenn der erste Berechnungsbaustein 10 für die doppelte Berechnung herangezogen wird. Ein Fehler in jenem Berechnungsbaustein 10 oder 20, welcher für die doppelte Berechnung herangezogen wird, kann jedoch wiederum dazu führen, dass ein möglicher Fehler nicht detektiert wird. Mitunter kann es daher zu Situationen kommen, in denen die Sicherheit, trotz Mehrkanaligkeit, nicht eindeutig gewährleistet werden kann.

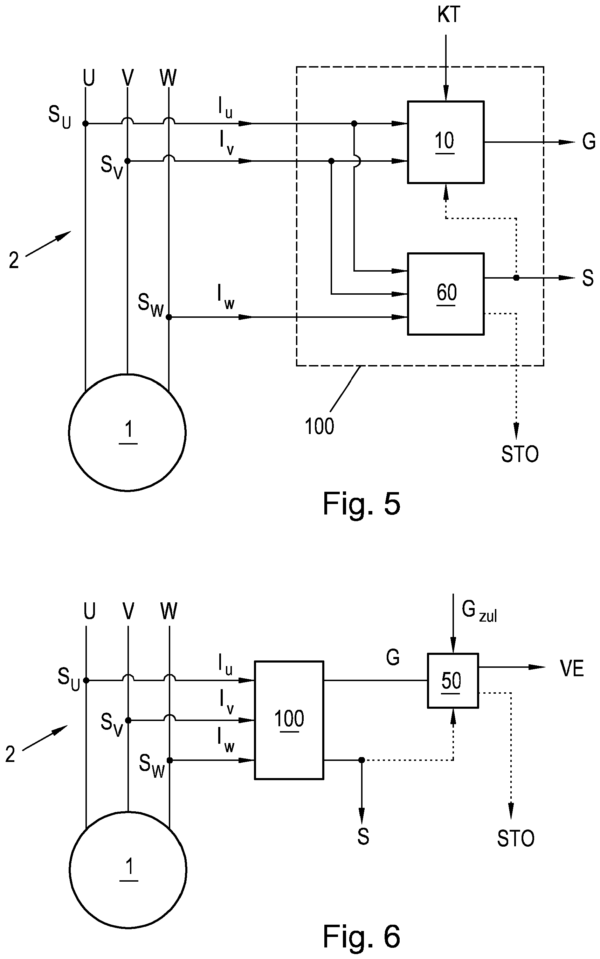

Anhand von Fig. 5 wird am Beispiel einer dreiphasigen Drehstrom-Synchronmaschine 1 in Sternschaltung das erfindungsgemäße Vorgehen beschrieben, wobei die Erfindung wie oben erwähnt natürlich auf eine beliebige Phasenanzahl n ≥ 3 verallgemeinert werden kann und auch auf eine n-Eckschaltung angewendet werden kann.

Es werden zumindest n-1 aktuelle Phasenströme Iᵤ,...,Iₙ₋₁ aus n-1 Phasen U,...,N-1 des n-phasigen Mehrphasenstromnetzes 2 erfasst. Im gezeigten Ausführungsbeispiel beispielsweise zwei (n-1) Phasenströme Iᵤ, Iᵥ der Phasen U, V des dreiphasigen (n=3) Mehrphasenstromnetzes 2. Mittels dieser zumindest n-1 aktuellen Stromwerten der Phasenströme Iᵤ,...,Iₙ₋₁ wird die aktuell wirkende Zustandsgröße G im Berechnungsbaustein 10 wie beschrieben berechnet. Zusätzlich werden die aktuellen Stromwerte aller n Phasenströme Iᵤ,...,Iₙ aus dem n-phasigen Netz erfasst und für eine Plausibilitätsprüfung der zumindest n-1 Stromwerte der Phasenströme Iᵤ,...,Iₙ₋₁ herangezogen. Es werden also alle n erfassten aktuellen Stromwerte aller Phasenströme Iᵤ,...,Iₙ selbst für eine Überprüfung herangezogen. Dadurch wird eine unmittelbare Kontrolle ermöglicht und damit Fehlerakkumulationen durch weitere Berechnungen minimiert. So würde beispielsweise die Ermittlung einer Zustandsgröße G aus den aktuellen Phasenströmen Iᵤ,...,Iₙ und eine darauf folgende Überprüfung der Plausibilität der aktuellen Phasenströme Iᵤ,...,Iₙ aus der zuvor ermittelten Zustandsgröße G einen zusätzlichen Rechenschritt und damit eine weitere Fehlerquelle bedeuten.

Hierzu ist ein Überwachungsbaustein 60 vorgesehen, dem die Stromwerte aller Phasenströme Iᵤ,...,Iₙ zugeführt wird. Die Plausibilitätsprüfung der zumindest n-1 Stromwerte der Phasenströme Iᵤ,...,Iₙ₋₁, die zur Ermittlung der Zustandsgröße G verwendet werden, erfolgt im Überwachungsbaustein 60 dadurch, dass alle n Phasenströme Iᵤ,...,Iₙ miteinander verknüpft werden und das Ergebnis der Verknüpfung zur Plausibilisierung herangezogen wird. Es wird natürlich eine Verknüpfung verwendet, die zu einem bekannten, erwartenden Ergebnis führt. Vorzugsweise erfolgt die Verknüpfung durch Anwendung des ersten Kirchhoff'schen Gesetzes auf alle n Phasenströme Iᵤ,...,Iₙ der n Phasen U,...N des Mehrphasenstromnetzes 2. Sowohl bei Sternschaltung, als auch bei n-Eck-Schaltung der Wicklungen der Drehstrom-Synchronmaschine 1 muss die Summe aller n Phasenströme Iᵤ,...,Iₙ gleich Null sein. Auf diese Weise kann eine einfache Kontrolle der Plausibilität der n erfassten, aktuellen Stromwerte der Phasenströme Iᵤ,...,Iₙ erfolgen. Ergibt die Summe der n Phasenströme Iᵤ,...,Iₙ nicht Null, muss ein Fehler vorliegen, beispielsweise in Form eines defekten Stromsensors Sᵤ, Sᵥ, S_{w}, eines beschädigten oder gelösten Kabels oder ähnliches. In jedem Fall ist dem Ergebnis der Berechnung der Zustandsgröße G im Falle einer negativen Plausibilitätsprüfung nicht zu trauen und es ist eine entsprechende Handlung zu setzen.

Vorteilhaft wird das Ergebnis der Plausibilitätsprüfung vom Überwachungsbaustein 60 in Form eines Plausibilitätssignals S ausgegeben.

Das ausgegebene Plausibilitätssignal S kann damit im beschriebenen Ausführungsbeispiel nach Fig.5 beispielsweise, die Information enthalten, dass die Plausibilitätsprüfung positiv ist und tatsächlich die erfassten n-1 aktuellen Stromwerte der n-1 Phasenströme Iᵤ, Iᵥ in Kombination mit dem n-ten Phasenstrom I_{w} in Summe Null ergeben. Dies bedeutet, dass die erfassten n-1 aktuellen Stromwerte der Phasenströme Iᵤ, Iᵥ richtig von den entsprechenden Sensoren Sᵤ, Sᵥ erfasst wurden und eine korrekte Basis für die weitere Berechnung der Zustandsgröße G darstellen. In diesem Fall kann das Signal S beispielsweise auch dazu genutzt werden eine positive Statusmeldung, zum Beispiel in Form einer grünen Leuchtanzeige oder ähnlichem, auszugeben, oder an eine übergeordnete Regelungseinheit zu übergeben.

Im Falle einer negativen Plausibilitätsprüfung würde das Plausibilitätssignal S z.B. anzeigen, dass zumindest einer der n Stromsensoren Sᵤ, Sᵥ, S_{w} schadhaft ist bzw. fehlerhaft misst. Da dem zumindest einen Berechnungsbaustein 10 daher aktuelle Stromwerte Iᵤ, Iᵥ zugeführt werden, welche möglicherweise fehlerhaft sind, kann auch die errechnete Zustandsgröße G keine geeignete Basis für eine weitere Kontrolle der Funktion der Drehstrom-Synchronmaschine 1 darstellen. In diesem Fall kann das Plausibilitätssignal S auch zur Ausgabe einer negativen Statusmeldung, beispielsweise zur Aktivierung einer roten Warnleuchte oder dergleichen herangezogen werden, oder an eine übergeordnete Regelungseinheit zur weiteren Verarbeitung übermittelt werden. Selbstverständlich ist im negativen Fall auch das Aktivieren eines unmittelbaren Stopps der Drehstrom-Synchronmaschine 1, beispielsweise in Form einer Impulssperre STO (Save Torque Off Funktion), wie in Fig.5 angedeutet, denkbar. Das Plausibilitätssignal S kann, wie in Fig. 5 angedeutet, auch dem Berechnungsbaustein 10 zugeführt werden und dafür sorgen, dass im Falle einer negativen Plausibilitätsprüfung die Berechnung der Zustandsgröße G nicht durchgeführt wird.

Der Berechnungsbaustein 10 und der Überwachungsbaustein 60 können separate Hardwareeinheiten sein, können aber auch in einer gemeinsamen Hardwareeinheit integriert sein, wie z.B. in einer Überwachungseinheit 100, wie in Flg.5 angedeutet. Ebenso ist es natürlich möglich die Funktion des Berechnungsbausteins 10 und/oder des Überwachungsbausteins 60 sowohl in Hardware oder in Software auszuführen.

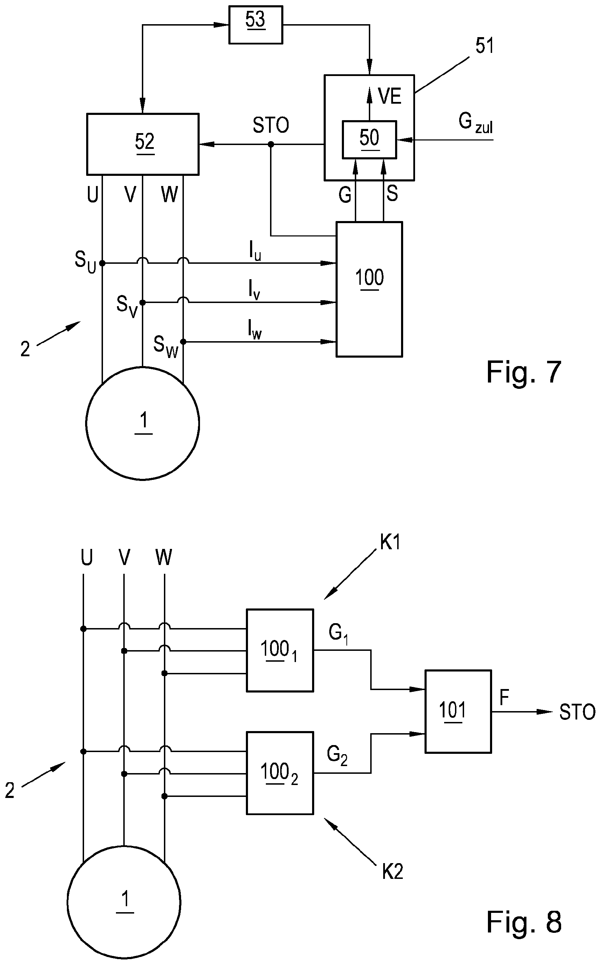

Um eine besonders hohe Sicherheit zu erreichen, können der Berechnungsbaustein 10 und/oder der Überwachungsbaustein 60, bzw. die Überwachungseinheit 100, auch redundant ausgeführt werden. Dazu können beispielsweise mehreren Berechnungsbausteinen 10 unterschiedliche Paare von Stromwerten Iᵤ, Iᵥ, I_{w} zugeführt werden, aber auch mehrere Berechnungsbausteine 10, Überwachungsbausteine 60, bzw. Überwachungseinheiten 100, nebeneinander ausgeführt sein, um eine höhere Ausfallsicherheit zu erreichen. Werden an diesen redundanten Berechnungsbausteinen 10, Überwachungsbausteinen 60, bzw. Überwachungseinheiten 100, ungleiche Ergebnisse ausgegeben, so kann ebenfalls eine Impulssperre STO ausgelöst werden. Dazu können die Ergebnisse dieser Bausteine miteinander verglichen werden. Damit kann auch eine klassische mehrkanalige Struktur aufgebaut werden, wie in Fig.8 dargestellt, in der in jedem Kanal K1, K2 dieselbe Berechnung durchgeführt wird, beispielsweise in dem in jedem Kanal K1, K2 eine Überwachungseinheit 100₁, 100₂ mit Berechnungsbausteinen 10 und Überwachungsbausteinen 60 implementiert wird. Die in jedem Kanal K1, K2 berechnete physikalische Größe G1, G2 kann dann in einer Recheneinheit 101 miteinander verglichen werden. Sind die in den verschiedenen Kanälen K1, K2 berechneten physikalischen Größen G1, G2 nicht gleich (vorzugsweise innerhalb eines vorgegebenen Toleranzbandes) kann ebenfalls ein Signal F ausgegeben werden, z.B. eine Impulssperre STO aktiviert werden. Durch diese Redundanz kann die Sicherheit noch weiter erhöht werden.

Wie in Fig. 6 erkennbar ist, kann die ermittelte, aktuell wirkende Zustandsgröße G in einem Vergleichsbaustein 50 auch mit einem Grenzwert G_{zul} verglichen werden und ein entsprechendes Vergleichsergebnis VE ausgegeben werden. Die Vorgabe eines zulässigen Grenzwerts G_{zul} der Zustandsgröße G kann beispielsweise über eine nicht weiter dargestellte, übergeordnete Regelungseinheit erfolgen und kann sich über die Zeit auch ändern. Ein Grenzwert G_{zul} kann sich während des Betriebs der Drehstrom-Synchronmaschine 1 auch zeitlich ändern, beispielsweise wenn von der Drehstrom-Synchronmaschine 1 während einer bestimmten Zeit unterschiedliche Aufgaben verrichtet werden. Dieser Vergleich kann auch in jedem Kanal einer mehrkanaligen Struktur durchgeführt werden.

Das Plausibilitätssignal S kann auch verwendet werden, um den Vergleichsbaustein 50 im Falle einer positiven Plausibilitätsprüfung zu aktivieren oder im anderen Fall zu deaktivieren. Dazu kann dem Vergleichsbaustein 50 auch das Plausibilitätssignal S zugeführt werden, wie in Fig. 6 angedeutet. Im Falle einer negativen Plausibilitätsprüfung kann das im Vergleichsbaustein 50 auch dazu genutzt werden, um immer ein negatives Vergleichsergebnis VE auszugeben oder die Impulssperre STO zu aktivieren.

Der im Vergleichsbaustein 50 vorgenommene Vergleich gibt Auskunft über das Erreichen, Überschreiten oder auch nicht Erreichen möglicher Bereiche bzw. Werte der Zustandsgröße G, welche es beispielsweise aus Sicherheitsgründen zu vermeiden gilt. Die Ausgabe des Vergleichsergebnisses VE ermöglicht eine Vielzahl an möglichen Handlungen, welche basierend auf das Vergleichsergebnis VE gesetzt werden können. Beispielsweise können entsprechende Statusmeldungen erfolgen, wie z.B. grüne oder rote Leuchtanzeigen, ein akustisches Warnsignal, das Absetzen einer Fehlernachricht an eine übergeordnete Regelungseinheit, etc. Ein negativer Vergleich, also das Erreichen oder sogar Überschreiten eines zulässigen Grenzwertes G_{zul} kann auch zum unmittelbaren Stopp der Drehstrom-Synchronmaschine 1 führen, beispielsweise in Form einer aktivierten Impulssperre STO. Infolge der Impulssperre STO erhält die Drehstrom-Synchronmaschine 1 keinen Versorgungsstrom mehr der zu einer Drehbewegung führen kann. Die Impulssperre STO sorgt somit dafür, dass die Drehstrom-Synchronmaschine 1 stillgesetzt wird.

Anhand von Fig.7 wird noch beschrieben, wie die erfindungsgemäße sichere Ermittlung der Zustandsgröße G zum Betrieben einer Drehstrom-Synchronmaschine 1 verwendet werden kann. Die Drehstrom-Synchronmaschine 1 wird in bekannter Weise von einem Leistungsteil 52, beispielsweise in Form einer Umrichterschaltung, mit elektrischem Strom versorgt. Der Leistungsteil 52 wird dazu von einer Motorsteuereinheit 53 angesteuert, beispielsweise in Form eines bekannten PWM-Signals. Die Motorsteuereinheit 53 kann dazu auch Befehle oder Stellgrößenvorgaben, wie z.B. ein gewünschtes Drehmoment, von einer einer übergeordneten Regelungseinheit 51 erhalten. Die Motorsteuereinheit 53 könnte dazu auch in der übergeordneten Regelungseinheit 51 integriert sein. Die Phasenströme Iᵤ, Iᵥ, I_{w} des Mehrphasenstromnetz 2, das den Leistungsteil 52 mit der Drehstrom-Synchronmaschine 1 verbindet, werden erfasst und in der Überwachungseinheit 100 wird daraus die Zustandsgröße G der Drehstrom-Synchronmaschine 1 wie beschrieben ermittelt. Im gezeigten Ausführungsbeispiel ist der Vergleichsbaustein 50 in der übergeordneten Regelungseinheit 51 integriert (entweder als Hardware oder Software). Der Vergleichsbaustein 50 erhält die ermittelte Zustandsgröße G, und gegebenenfalls auch das Plausibilitätssignal S, und vergleicht die Zustandsgröße G mit einem vorgegebenen zulässigen Grenzwert G_{zul}- Das Vergleichsergebnis VE kann in der übergeordneten Regelungseinheit 51, beispielsweise in Form einer SLT-Funktion im Falle eines Drehmoments als Zustandsgröße G, weiterverarbeitet werden. In Abhängigkeit von der Umsetzung der Weiterverarbeitung können verschiedene Handlungen ausgelöst werden. In sicherheitskritischen Anwendungen ist die Auslösung einer Impulssperre STO der Drehstrom-Synchronmaschine 1 üblich, mit diese stillgesetzt wird. Die Impulssperre STO kann aber auch durch die Überwachungseinheit 100 ausgelöst werden.

## Patentansprüche

1. Verfahren zur sicheren Ermittlung einer Zustandsgröße (G) einer Drehstrom-Synchronmaschine (1), die von einem Mehrphasenstromnetz (2) mit n Phasen (U,...,N), mit n≥3, mit elektrischem Strom versorgt wird, wobei Stromwerte von zumindest n-1 Phasenströmen (Iᵤ,...,Iₙ₋₁) aus zumindest n-1 Phasen (U,...,N-1) des Mehrphasenstromnetzes (2) erfasst werden und mittels der zumindest n-1 aktuellen Stromwerte (Iᵤ,... ,Iₙ₋₁) die Zustandsgröße (G) ermittelt wird, wobei Stromwerte aller n Phasenströme (Iᵤ,...,Iₙ) aus dem n-phasigen Mehrphasenstromnetz (2) erfasst werden und die n Phasenströme (Iᵤ,... ,Iₙ) miteinander verknüpft werden und das Ergebnis der Verknüpfung aller n Phasenströme (Iᵤ,...,Iₙ) für eine Plausibilitätsprüfung der für die Ermittlung der Zustandsgröße (G) verwendeten n-1 Phasenströme (Iᵤ,...,Iₙ₋₁) herangezogen wird, wobei aus den zumindest n-1 Stromwerten ein Stromraumzeiger ermittelt wird, **dadurch gekennzeichnet, dass** unter Verzicht auf eine Verwendung des Verdrehwinkels (ϕ) angenommen wird, dass der Stromraumzeiger einer maximalen drehmomentbildenden Stromkomponente (i_{q,max}) entspricht **und dass** aus der maximalen drehmomentbildenden Stromkomponente (i_{q,max}) die Zustandsgröße (G) der Drehstrom-Synchronmaschine (1) ermittelt wird.

2. Verfahren nach Anspruch 1, **dadurch gekennzeichnet, dass** die Plausibilitätsprüfung durch Bildung der Summe aller n Phasenströme (Iᵤ,...,Iₙ) der n Phasen (U,...,N) des Mehrphasenstromnetzes (2) erfolgt.

3. Verfahren nach Anspruch 1 oder 2, **dadurch gekennzeichnet, dass** das Ergebnis der Plausibilitätsprüfung in Form eines Plausibilitätssignals S ausgegeben wird.

4. Verfahren nach einem der Ansprüche 1 bis 3, **dadurch gekennzeichnet, dass** aus der drehmomentenbildenden Stromkomponente (l_{q,max}) ein Drehmoment (M) als Zustandsgröße (G) ermittelt wird.

5. Verfahren nach einem der Ansprüche 1 bis 4, **dadurch gekennzeichnet, dass** die Zustandsgröße (G) mit einem zulässigen Grenzwert (G_{zul}) verglichen wird und ein Vergleichsergebnis (VE) ausgegeben wird.

6. Verfahren nach einem der Ansprüche 1 bis 5, **dadurch gekennzeichnet, dass** die Zustandsgröße (G1, G2) in mehreren Kanälen (K1, K2) berechnet wird und die in den Kanälen (K1, K2) berechneten Zustandsgrößen (G1, G2) miteinander verglichen werden und das Ergebnis des Vergleichs als Signal (F) ausgegeben wird.

7. Verwendung des Verfahrens nach einem der Ansprüche 1 bis 6 zum Betreiben einer Drehstrom-Synchronmaschine (1), wobei die berechnete Zustandsgröße (G) verwendet wird, um den Betrieb der Drehstrom-Synchronmaschine (1) zu überwachen.

8. Verwendung nach Anspruch 7, **dadurch gekennzeichnet, dass** bei negativer Plausibilitätsprüfung oder bei Erreichen oder Überschreiten des Grenzwertes (G_{zul}) oder bei negativen Vergleich der Zustandsgrößen (G1, G2) mehrerer Kanäle (K1, K2) eine Impulssperre (STO) der Drehstrom-Synchronmaschine (1) ausgelöst wird.

9. Vorrichtung zur sicheren Ermittlung einer Zustandsgröße (G) einer Drehstrom-Synchronmaschine (1), die zur Stromversorgung mit einem Mehrphasenstromnetz (2) mit n Phasen (U,...,N), mit n≥3, verbunden ist, wobei ein Berechnungsbaustein (10) vorgesehen ist, der ausgestaltet ist aus zumindest n-1 Stromwerten von zumindest n-1 Phasenströmen (Iᵤ,...,Iₙ₋₁) aus zumindest n-1 Phasen (U,...,N-1) des Mehrphasenstromnetzes (2) die Zustandsgröße (G) zu ermitteln, wobei ein Überwachungsbaustein (60) vorgesehen ist, der ausgestaltet ist, alle n Phasenströme (Iᵤ,...,Iₙ) aus dem n-phasigen Mehrphasenstromnetz (2) miteinander zu verknüpfen und eine Plausibilitätsprüfung der für die Berechnung der Zustandsgröße (G) verwendeten n-1 Phasenströme (Iᵤ,...,Iₙ₋₁) durchzuführen, **dadurch gekennzeichnet, dass** der Berechnungsbaustein (10) ausgestaltet ist, um aus den zumindest n-1 Stromwerten einen Stromraumzeiger zu ermitteln, welcher unter Verzicht auf eine Verwendung des Verdrehwinkels (ϕ) einer maximalen drehmomentbildenden Stromkomponente (i_{q,max}) entspricht, und aus der maximalen drehmomentbildenden Stromkomponente (i_{q,max}) die Zustandsgröße (G) zu ermitteln.

10. Vorrichtung nach Anspruch 9, **dadurch gekennzeichnet, dass** ein Vergleichsbaustein (50) vorgesehen ist, der ausgestaltet ist die berechnete Zustandsgröße (G) mit einem zulässigen Grenzwert (G_{zul}) zu vergleichen.

11. Vorrichtung nach Anspruch 10, **dadurch gekennzeichnet, dass** der Überwachungsbaustein (60) ausgestaltet ist, das Ergebnis der Plausibilitätsprüfung als ein Plausibilitätssignal (S) an den Vergleichsbaustein (50) zu übergeben.

12. Vorrichtung nach einem der Ansprüche 9 bis 11, **dadurch gekennzeichnet, dass** mehrere Kanäle (K1, K2) vorgesehen sind, wobei jeder Kanal (K1, K2) ausgestaltet ist eine Zustandsgröße (G1, G2) zu berechnen, und eine Recheneinheit (101) vorgesehen ist, die ausgestaltet ist die berechneten Zustandsgrößen (G1, G2) zu vergleichen und das Ergebnis des Vergleichs als Signal (F) auszugeben.

## Claims

1. A method for reliably determining a state variable (G) of a polyphase synchronous machine (1) that is supplied with electric current by a polyphase power network (2) with n phases (U,...,N), where n≥3, wherein current values of at least n-1 phase currents (Iᵤ,...,Iₙ₋₁) from at least n-1 phases (U,... ,N-1) of the polyphase power network (2) are detected and the state variable (G) is determined by means of the at least n-1 instantaneous current values (Iᵤ,...,Iₙ₋₁), wherein current values of all n phase currents (Iᵤ,...,Iₙ) from the n-phase polyphase power network (2) are detected and the n phase currents (Iᵤ,...,Iₙ) are correlated with one another and the result of the correlation of all n phase currents (Iᵤ,...,Iₙ) is used for a plausibility check of the n-1 phase currents (Iᵤ,...,Iₙ₋₁) used for determining the state variable (G), wherein a current space vector is determined with the at least n-1 phase currents (Iᵤ,...,Iₙ₋₁), **characterized in that** without the use of the rotation angle (ϕ) it is assumed that the current space vector corresponds to a maximum torque-generating current component (i_{q,max}) **and in that** the state variable (G) of the polyphase synchronous machine (1) is determined with the maximum torque-generating current component (i_{q,max}).

2. The method according to claim 1, **characterized in that** the plausibility check is performed through summation of all n phase currents (Iᵤ,...,Iₙ) of the n phases (U,...,N) of the polyphase power network (2).

3. The method according to claim 1 or 2, **characterized in that** the result of the plausibility check is outputted in the form of a plausibility signal S.

4. The method according to one of claims 1 to 3, **characterized in that** a torque (M) is determined as a state variable (G) from the first current component (I_{q}).

5. The method according to one of claims 1 to 4, **characterized in that** the state variable (G) is compared to a permissible threshold value (G_{zul}) and a comparative result (VE) is outputted.

6. The method according to one of claims 1 to 5, **characterized in that** the state variable (G1, G2) is calculated in several channels (K1, K2) and the state variables (G1, G2) calculated in the channels (K1, K2) are compared to one another and the result of the comparison is outputted as a signal (F).

7. A use of the method according to one of claims 1 to 6 for operating a polyphase synchronous machine (1), wherein the calculated state variable (G) is used to monitor the operation of the polyphase synchronous machine (1).

8. The use according to claim 7, **characterized in that,** in the event of a negative plausibility check or the reaching or overshooting of the threshold value (G_{zul}), or in the event of a negative comparison of the state variables (G1, G2) of several channels (K1, K2), a save torque off function (STO) of the polyphase synchronous machine (1) is triggered.

9. A device for reliably determining a state variable (G) of a polyphase synchronous machine (1) that is connected to a polyphase power network (2) with n phases (U,...,N) for its power supply, where n≥3, wherein a calculation module (10) is provided which is arranged to determine the state variable (G) from at least n-1 current values of at least n-1 phase currents (Iᵤ,...,Iₙ₋₁) from at least n-1 phases (U,...,N-1) of the polyphase power network (2), wherein a monitoring module (60) is provided which is arranged to correlate all n phase currents (Iᵤ,...,Iₙ) from the n-phase polyphase power network (2) with one another and to carry out a plausibility check of the n-1 phase currents (Iᵤ,...,Iₙ₋₁) used for the calculation of the state variable (G), **characterized in that** the calculation module (10) is arranged to determine a current space vector with the n-1 current values, which, without the use of the rotation angle (ϕ), corresponds to a maximum torque-generating current component (i_{q,max}) and to determine the state variable (G) with the maximum torque-generating current component (i_{q,max}).

10. The device according to claim 9, **characterized in that** a comparison module (50) is provided which is arranged to compare the calculated state variable (G) to a permissible threshold value (G_{zul}).

11. The device according to claim 10, **characterized in that** the monitoring module (60) is arranged to transmit the result of the plausibility check as a plausibility signal (S) to the comparison module (50).

12. The device according to one of claims 9 to 11, **characterized in that** several channels (K1, K2) are provided, with each channel (K1, K2) being arranged to calculate a state variable (G1, G2), and a calculation unit (101) is provided which is arranged to compare the calculated state variables (G1, G2) and to output the result of the comparison as a signal (F).

## Revendications

1. Procédé permettant la détermination fiable d'une variable d'état (G) d'une machine synchrone triphasée (1) alimentée en courant électrique par un réseau polyphasé (2) à n phases (U,...,N), avec n ≥ 3, des valeurs de courant d'au moins n - 1 courants de phase (Iᵤ,...,lₙ₋₁) étant enregistrées à partir d'au moins n - 1 phases (U,...,N-1) du réseau polyphasé (2) et la variable d'état (G) étant déterminée à l'aide d'au moins n - 1 valeurs de courant (Iᵤ,...,Iₙ₋₁) actuelles, des valeurs de courant de tous les n courants de phase (Iᵤ,...,Iₙ) étant enregistrées à partir du réseau polyphasé à n phases (2) et les n courants de phase (Iᵤ,...,Iₙ) étant liés les uns aux autres et le résultat de la liaison de tous les n courants de phase (Iᵤ,...,Iₙ) étant utilisé pour un contrôle de plausibilité des n - 1 courants de phase (Iᵤ,...,Iₙ₋₁) utilisés pour la détermination de la variable d'état (G), un vecteur spatial de courant étant déterminé à partir des au moins n - 1 valeurs de courant, **caractérisé en ce que,** en renonçant à l'utilisation de l'angle de torsion (ϕ), il est supposé que le vecteur spatial de courant correspond à une composante de courant génératrice de couple maximale (i_{q,max}) **et en ce que** la variable d'état (G) de la machine synchrone triphasée (1) est déterminée à partir de la composante de courant génératrice de couple maximale (i_{q,max}).

2. Procédé selon la revendication 1, **caractérisé en ce que** le contrôle de plausibilité est effectué en faisant la somme de tous les n courants de phase (Iᵤ,...,Iₙ) des n phases (U,...,N) du réseau polyphasé (2).

3. Procédé selon la revendication 1 ou 2, **caractérisé en ce que** le résultat du contrôle de plausibilité est délivré sous la forme d'un signal de plausibilité S.

4. Procédé selon l'une des revendications 1 à 3, **caractérisé en ce qu'**un couple (M) est déterminé comme variable d'état (G) à partir de la composante de courant génératrice de couple (I_{q,max}).

5. Procédé selon l'une des revendications 1 à 4, **caractérisé en ce que** la variable d'état (G) est comparée à une valeur limite admissible (G_{zul}) et un résultat de comparaison (VE) est délivré.

6. Procédé selon l'une des revendications 1 à 5, **caractérisé en ce que** la variable d'état (G1, G2) est calculée dans plusieurs canaux (K1, K2) et les variables d'état (G1, G2) calculées dans les canaux (K1, K2) sont comparées l'une à l'autre et le résultat de la comparaison est délivré en tant que signal (F).

7. Utilisation du procédé selon l'une des revendications 1 à 6 pour faire fonctionner une machine synchrone triphasée (1), dans lequel la variable d'état (G) calculée est utilisée pour surveiller le fonctionnement de la machine synchrone triphasée (1).

8. Utilisation selon la revendication 7, **caractérisée en ce qu'**en cas de contrôle de plausibilité négatif ou si la valeur limite (G_{zul}) est atteinte ou dépassée ou en cas de comparaison négative des variables d'état (G1, G2) de plusieurs canaux (K1, K2), un blocage d'impulsions (STO) de la machine synchrone triphasée (1) est déclenché.

9. Dispositif permettant la détermination fiable d'une variable d'état (G) d'une machine synchrone triphasée (1) qui est connectée à un réseau polyphasé (2) à n phases (U,...,N), avec n ≥ 3, pour l'alimentation en courant, un module de calcul (10) étant prévu et configuré pour déterminer la variable d'état (G) à partir d'au moins n - 1 valeurs de courant d'au moins n - 1 courants de phase (Iᵤ,...,Iₙ₋₁) à partir d'au moins n - 1 phases (U,...,N-1 ) du réseau polyphasé (2), un module de surveillance (60) étant prévu et configuré pour lier tous les n courants de phase (Iᵤ,...,Iₙ) du réseau polyphasé (2) à n phases les uns aux autres et pour effectuer un contrôle de plausibilité des n - 1 courants de phase (Iᵤ,...,Iₙ₋₁) utilisés pour le calcul de la variable d'état (G), **caractérisé en ce que** le module de calcul (10) est configuré pour déterminer un vecteur spatial de courant à partir des au moins n - 1 valeurs de courant, lequel vecteur spatial de courant, en renonçant à l'utilisation de l'angle de torsion (ϕ), correspond à une composante de courant génératrice de courant maximale (i_{q,max}), et pour déterminer la variable d'état (G) à partir de la composante de courant génératrice de couple maximale (i_{q,max}).

10. Dispositif selon la revendication 9, **caractérisé en ce qu'**un module de comparaison (50) est prévu et configuré pour comparer la variable d'état (G) calculée avec une valeur limite admissible (G_{zul}).

11. Dispositif selon la revendication 10, **caractérisé en ce que** le module de surveillance (60) est configuré pour transmettre le résultat du contrôle de plausibilité en tant que signal de plausibilité (S) au module de comparaison (50).

12. Dispositif selon l'une des revendications 9 à 11, **caractérisé en ce que** plusieurs canaux (K1, K2) sont prévus, chaque canal (K1, K2) étant configuré pour calculer une variable d'état (G1, G2), et une unité de calcul (101) étant prévue et configurée pour comparer les variables d'état (G1, G2) calculées et pour délivrer le résultat de la comparaison en tant que signal (F).
